# EUROPÄISCHE PATENTSCHRIFT

(11) **EP 2 490 253 B1**
(45) Veröffentlichungstag und Bekanntmachung des Hinweises auf die Patenterteilung: **09.10.2013**
(21) Anmeldenummer: 12152474.8
(22) Anmeldetag: 25.01.2012
(51) Int. Cl.: H01L 21/67

(54) **Vorrichtung und Verfahren zur Abnahme mindestens eines chipförmigen Halbleiterbauelements von einer Folie**
Device and method for removing at least one chip-shaped semiconductor element from a foil
Dispositif et procédé destinés à extraire au moins un composant semi-conducteur sous forme de puce à partir d'une feuille

(30) Priorität: 17.02.2011 DE 102011004287; 30.11.2011 DE 102011087388
(43) Veröffentlichungstag der Anmeldung: 22.08.2012
(73) Patentinhaber: SEMIKRON Elektronik GmbH & Co. KG, 90431 Nürnberg (DE)
(72) Erfinder: Studt, Armin, 91074 Herzogenaurach (DE)

(56) Entgegenhaltungen:
- JP-A- 2003 115 465
- JP-A- 2009 188 157
- JP-A- 2009 206 134
- US-A1- 2003 060 021

## Beschreibung

Die Erfindung beschreibt eine Vorrichtung und ein Verfahren zur gleichzeitigen Abnahme mindestens eines chipförmigen Halbleiterbauelements, insbesondere eines Halbleiterbauelements mit einer Dicke von weniger als 130µm oder bevorzugt von weniger als 100µm von einer Folie. Derartige Halbleiterbauelemente liegen beispielhaft nach der Zerteilung von Wafern, die auf einer adhäsiven Folie angeordnet sind vor. Vorteilhafterweise handelt es sich bei den Halbleiterbauelementen um Leistungshalbleiterbauelemente wie IGBTs oder Leistungsdioden.

Je dünner diese Halbleiterbauelement sind, desto größer ist die Gefahr einer Beschädigung, insbesondere von Bruch, bei der Abnahme dieser von der Folie.

Die genannten Vorrichtungen und Verfahren finden bevorzugt in sog. Pic - and - Place - Anlagen zur Bestückung von Substraten mit Halbleiterbauelementen Anwendung.

Aus der JP 2009 206134 A ist ein Verfahren zur Abnahme eines dünnen an einer Folie anhaftenden Chips, wobei der Chip mittels einer Drückvorrichtung, die ein Drückelement aufweist, das gegen den Chip drückt, von der Folie abgenommen wird, bekannt.

Aus der JP 2009 188157 A ist eine Abnahmeeinrichtung zur Abnahme eines dünnen an einer Folie anhaftenden Chips, wobei der Chip mittels einer Drückvorrichtung, die mehrere Drückelemente aufweist, die gegen den Chip drücken, von der Folie abgenommen wird, bekannt.

Aus der JP 2003 115465 A ist eine Abnahmeeinrichtung zur Abnahme eines dünnen an einer Folie anhaftenden Chips, wobei der Chip mittels einer Drückvorrichtung, die ein Drückelemente aufweist, die gegen den Chip drückt, von der Folie abgenommen wird und von einer Ansaugvorrichtung gehalten wird, bekannt.

Aus der US 2003 / 0060021 A1 ist ein Verfahren zum Abziehen eines an einem segmentierten Halbleiterwafer anhafteten Bandes bekannt.

Der Erfindung liegt die Aufgabe zugrunde eine Vorrichtung und ein Verfahren zur Abnahme mindestens eines chipförmigen Halbleiterbauelements von einer Folie vorzustellen, wobei die Gefahr einer Beschädigung deutlich reduziert wird.

Die Aufgabe wird erfindungsgemäß gelöst durch eine Vorrichtung mit den Merkmalen des Anspruchs 1, sowie durch ein Verfahren gemäß Anspruch 7. Bevorzugte Ausführungsformen sind in den jeweiligen abhängigen Ansprüchen beschrieben.

Die Erfindung beschreibt eine Vorrichtung zur gleichzeitigen Abnahme mindestens eines chipförmigen Halbleiterbauelements von einer adhäsiven Folie gemäß dem Anspruch 1.

Die Fläche des Kontaktbereichs der Anhebeeinrichtung ist bevorzugt größer als diejenige des oder der, auf der ersten Hauptfläche der Folie angeordneten in einem Schritt abzunehmenden, Halbleiterbauelemente und überragt dieses oder diese hierbei allseitig.

Die stiftförmigen Anhebemittel weisen ein spitzes oder balliges Ende auf, die durch die jeweils zugeordneten Ausnehmungen hindurchtreten und die Ebene des Kontaktbereichs überragen können und hierbei die Folie verformen. Hierbei bleiben die Ansaugausnehmungen mit der Folie verbunden und das oder die Halbleiterbauelemente werden partiell oder vollständig von der Folie abgehoben, wodurch die Adhäsionskräfte zwischen Halbleiterbauelement und Folie geringer werden und das oder die Halbleiterbauelemente durch die Abnahmevorrichtung abgenommen werden können ohne beschädigt zu werden. Spitze Enden der Anhebemittel können hierbei die Folie durchdringen, während ballige Enden die Folie in der Regel nur verformen können.

Die Ansaugausnehmungen können als konzentrisch angeordnete Gräben und / oder als auf der Kontaktbereich partiell gleichmäßig oder unregelmäßig verteilte Löcher ausgebildet sein.

Weiterhin ist es vorteilhaft, wenn die die Anhebeeinrichtung eine Thermoeinrichtung zur Änderung der Temperatur der adhäsiven Folie aufweist. Je nach Anwendungszweck, beispielhaft abhängig von der verwendeten Folie, kann es hierbei sinnvoll sein die Temperatur zu erniedrigen oder zu erhöhen. Eine Verringerung der Temperatur bietet sich beispielhaft an um die adhäsive Kraft zwischen der Folie und dem abzunehmenden Halbleiterbauelement zu verringern. Ein Erhöhung der Temperatur bietet sich beispielhaft an um die Elasitzität der Folie zu erhöhen.

Häufig ist es notwendig, dass derartige Temperaturänderungen um mindestens 20°C vornehmbar sind. Eine derartige Thermoeinrichtung kann beispielhaft als ein Peltierelement ausgebildet sein.

Das erfindungsgemäße Verfahren zum Betrieb einer derartigen Vorrichtung weist die folgenden Schritte gemäß dem Anspruch 7 auf.
Unter dem Begriff "Unterdruck" wird die Differenz zum Atmosphärendruck (ca. 100 kPa) bezeichnet, wobei größere Werte eine größere Differenz beschreiben und somit die Ansaugwirkung größer ist.
Der Unterdruck wird während des Verfahrens kontrolliert verändert also angepasst. Somit kann der Unterdruck an die unterschiedlich Ausdehnung der Kontaktfläche der Folie mit dem Kontaktbereich der Anhebeeinrichtung angepasst werden. Eine bevorzugte Grenze dieser Regelung bzw. Anpassung liegt hierbei bei 10% des Wertes des Unterdrucks.
Alternativ oder zusätzlich kann es ebenso bevorzugt sein unterschiedliche Ansaugausnehmungen mit unterschiedlichen Werten des Unterdrucks zu beaufschlagen. Hierbei ist es meist vorteilhaft diejenigen Ansaugausnehmungen die weiter mittig zum Halbleiterbauelement angeordnet sind mit einem geringeren Unterdruck zu beaufschlagen als diejenigen, die weiter zum Randbereich des Halbleiterbauelements angeordnet sind.
Auch kann es vorteilhaft sein, wenn der Unterdruck einer Ansaugausnehmung oder einer Gruppe von Ansaugausnehmungen während des Verformens konstant gehalten wird, während der Unterdruck an einer anderen oder eine Gruppe anderer Ansaugausnehmungen variiert wird.
- Partielles Verformen der Folie oberhalb des Kontaktbereichs durch Anheben der Folie mittels Anhebemitteln, die in zugeordneten Ausnehmungen 42 der Anhebeeinrichtung angeordnet sind.
- Abnehmen (II) mittels der Abnahmeeinrichtung des mindestens einen Halbleiterbauelements von der Folie.

Weiterhin ist es vorteilhaft mittels einer Thermoeinrichtung die Temperatur der Folie bei dem Abhebeprozess zu beeinflussen. Das Thermoelement kann hierbei die Temperatur der Folie erhöhen, alternativ oder zusätzlich kann es die Temperatur erniedrigen.

Diese Temperaturveränderung kann entweder kontinuierlich im Dauerbetrieb oder vorteilhafterweise gepulst betrieben werden. Bei einem Pulsbetrieb ist es darüber hinaus bevorzugt, wenn die Thermoregelung erst nach dem Anordnen der Abhebeeinrichtung zur Folie, also wenn der Kontaktbereich an der Folie anliegt, aktiviert wird.

Die erfinderische Lösung wird an Hand der Ausführungsbeispiele gemäß den Fig. 1 bis 4 weiter erläutert.

Fig. 1 zeigt eine erste Ausgestaltung einer erfindungsgemäßen Vorrichtung im seitlichen Schnitt.

Fig. 2 zeigt eine zweite Ausgestaltung einer erfindungsgemäßen Vorrichtung, ebenfalls im seitlichen Schnitt.

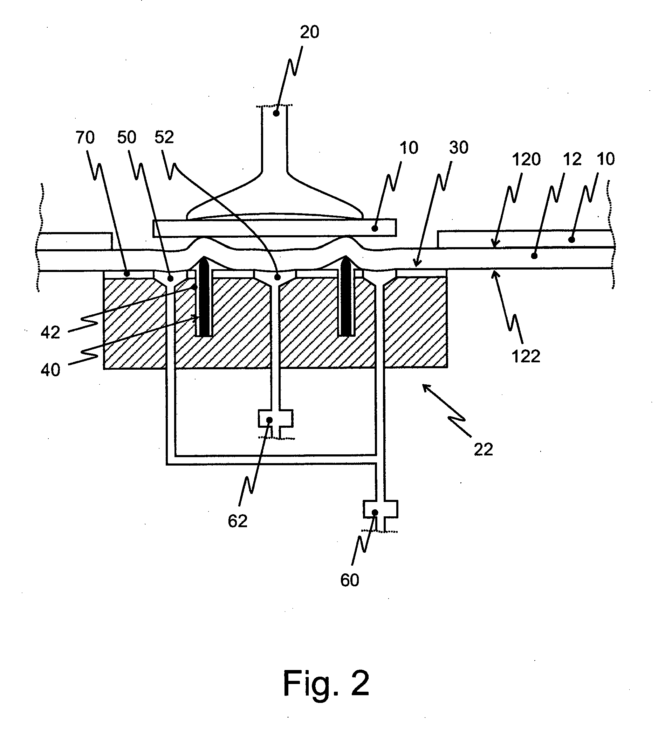

Fit. 3 zeigt die Anordnung gemäß Fig. 2 in Draufsicht.

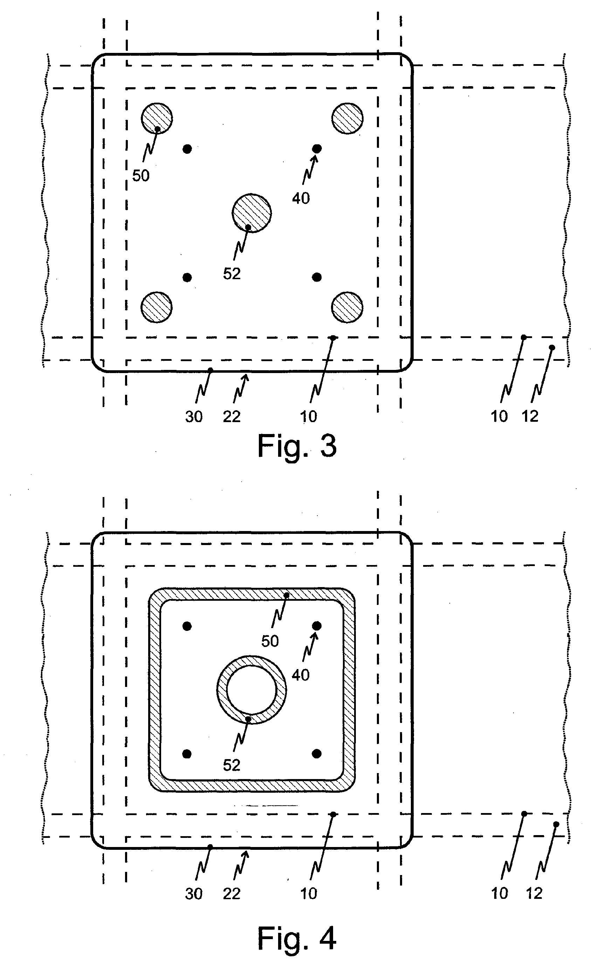

Fig. 4 zeigt eine dritte Ausgestaltung einer erfindungsgemäßen Vorrichtung in Draufsicht.

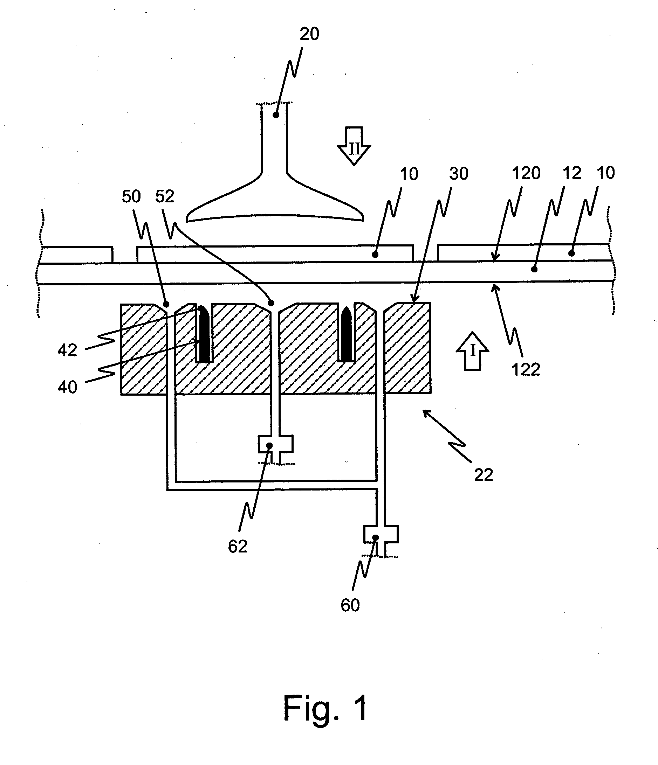

Fig. 1 zeigt eine Seitenansicht einer ersten erfindungsgemäßen Vorrichtung im Schnitt. Dargestellt ist ein Ausschnitt aus einem gesägten und auf einer adhäsiven Folie 12 angeordneten Wafer, der hierdurch eine Mehrzahl von Halbleiterbauelementen 10 ausbildet, die voneinander beabstandet vorliegen.

Die erfindungsgemäße Vorrichtung weist als wesentliche Komponenten eine Abnahmeeinrichtung 20, eine Anhebeeinrichtung 22 und mindestens eine Unterdruckregeleinrichtung 60, 62 auf.

Die Anhebeeinrichtung 22 ist ausgebildet als ein Metallformkörper mit Ausnehmungen 42 für stiftförmige Anhebemittel 40 und mit einer Mehrzahl von Ansaugausnehmungen 50, 52, hier ersten und zweiten Ansaugausnehmungen, die mit zugeordneten ersten und zweiten Unterdruckregeleinrichtungen 60, 62 verbunden sind. Dargestellt ist eine Situation zu Prozessbeginn des erfindungsgemäßen Verfahrens, bei dem die Anhebemittel 40 vollständig in den zugeordneten Ausnehmungen 42 angeordnet sind. Weiterhin ist die Anhebeeinrichtung 22 noch von der Folie 12 mit auf deren erster Hauptfläche 120 angeordneten Halbleiterbauelementen 10 beabstandet. In einem ersten nicht erfindungsrelevanten Prozessschritt wird der Kontaktbereich 30 der Anhebeeinrichtung 22 mit der zweite Hauptfläche 122 der Folie 12 in Kontakt gebracht. Wesentlich ist allerdings, dass die Anhebeeinrichtung 22 fluchtend mit dem abzunehmenden Halbleiterbauelement 10 angeordnet ist.

Daraufhin wird Unterdruck, geregelt mittels der Unterdruckregeleinrichtungen 60, 62 angelegt, wodurch die Folie 12 an die Ansaugausnehmungen 50, 52 angesaugt wird. Die Unterdruckregeleinrichtungen 60, 62 erzeugen beispielhaft einen konstanten Unterdruck von 40 kPa an allen Ansaugausnehmungen, der während der Verformung der Folie auf 42 kPa ansteigt.

Dies sind nur vorteilhafte Werte für eine bestimmte Kombination aus Halbleiterbauelement 10 und Folie 12, andere Halbleiterbauelemente, insbesondere Abhängig von deren Dicke, und andere Folien, insbesondere abhängig von deren Adhäsionskraft und Elastizität, können einen anderen Unterdruck und auch eine andere Änderung erfordern. Experimentell erfolgreich verwendet wurde ein Unterdruck zwischen 5 kPa und 60 kPa und eine Änderung von weniger als 10% dieses Wertes.

In der einfachsten Ausbildung des Verfahrens wird ein konstanter Unterdruck an alle Ansaugausnehmungen 50, 52 angelegt.

Vorteilhafter ist es einzelne Ansaugausnehmungen oder Gruppen von Ansaugausnehmungen mit unterschiedlichem Unterdruck zu beaufschlagen. Hierbei ist es wiederum vorteilhaft, die mittig zum Halbleiterbauelement angeordneten Ansaugausnehmungen oder Gruppen von Ansaugausnehmungen mit einem geringeren Unterdruck zu beaufschlagen als diejenigen Ansaugausnehmungen oder Gruppen von Ansaugausnehmungen, die weiter zum Randbereich des Halbleiterbauelements angeordnet sind.

In beiden Ausbildungen des Verfahrens ist es weiterhin vorteilhaft den Druck während der Phase der Verformung der Folie nicht konstant zu halten sondern definiert um nicht mehr als 10% vom ursprünglichen Unterdruck zu variieren, insbesondere zu vergrößern.

Diese Variation kann gleichmäßig für alle Ansaugausnehmungen erfolgen oder nur für einzelne Ansaugausnehmungen oder einzelne Gruppen von Ansaugausnehmungen.

Bei anliegendem konstantem Unterdruck wird das abzunehmende Halbleiterbauelement 10 mittels der Anhebemittel 40 aus der Ebene der übrigen Halbleiterbauelemente angehoben. Hierbei wird die Folie 12 partiell verformt.

Nach dem Anheben des Halbleiterbauelements 10, vgl. Fig. 2, von der Folie 12 kann dieses mittels des Abnahmeeinrichtung 20 angehoben und damit von der Folie 12 vollständig abgenommen werden.

Fig. 2 zeigt die Draufsicht auf eine zweite erfindungsgemäße Vorrichtung. Der dargestellte Verfahrensschritt entspricht dem zu Fig. 1 bereits beschriebenen, wobei die Folie 12 bereits verformt ist und das abzunehmende Halbleiterbauelement 10 bereits angehoben ist.

Diese Ausgestaltung der Vorrichtung unterscheidet sich wesentlich von derjenigen gemäß Fig. 1 durch ein zusätzlich vorgesehenes Peltierelement 70, das hier gleichzeitig, aber nicht notwendigerweise, den Kontaktbereich 30 der Anhebeeinrichtung 22 ausbildet. Zudem ist die Fläche des Kontaktbereichs 30 hier größer ausgebildet und reicht bis unter die benachbarten Halbleiterbauelemente 10.

Die zweite Unterdruckregeleinrichtung 62 erzeugt an den mittig angeordneten zweiten Ansaugausnehmungen 52 einen konstanten Unterdruck von 35 kPa, während die erste Unterdruckregeleinrichtung 60 an den äußeren, ersten Absaugeinrichtungen 50 ein konstanter Unterdruck von 40 kPa anlegt. Im Übrigen gilt für die Auswahl und Regelung des Unterdrucks das unter Fig. 1 beschriebene.

Fig. 3 zeigt schematisch die Anordnung gemäß Fig. 2 in Draufsicht. Dargestellt sind die matrixartig auf der Folie 12 angeordneten Halbleiterbauelemente 10 und die unterhalb eines dieser Halbleiterbauelemente 10 angeordnete Anhebeeinrichtung 22. Diese weist hier in den Eckbereichen des Halbleiterbauelements 10 vier erste Ansaugausnehmungen 50 und eine mittig zum Halbleiterbauelement 10 vorgesehene zweite Ansaugausnehmung 52 auf. Die ersten Ausnehmungen 50 bilden eine Gruppe, die über eine gemeinsame, nicht dargestellte erste Unterdruckregeleinrichtung 60 mit Unterdruck beaufschlagt werden, während die zweite Ausnehmung 52 mit einer eigenen zweiten Unterdruckregeleinrichtung 62 verbunden ist und von dieser mit Unterdruck beaufschlagt wird, vgl. auch Fig. 2 zur Lage und Verbindung der jeweiligen Unterdruckregeleinrichtungen.

Weiterhin dargestellt sind vier Anhebemittel 40, wobei diese jeweils in bevorzugter Weise nahe, aber nicht unmittelbar neben einer zugeordneten Ansaugeinrichtung 50 vorgesehen sind.

Fig. 4 zeigt schematisch eine dritte Ausgestaltung einer erfindungsgemäßen Vorrichtung in Draufsicht. Im Gegensatz zur Ausgestaltung gemäß Fig. 3 ist hier nur eine erste 50 und eine zweite Ansaugeinrichtung 52 vorgesehen, die jeweils mit einer zugeordneten nicht dargestellten ersten und zweiten Unterdruckregeleinrichtung verbunden sind.

Beide Ansaugeinrichtungen 50, 52 sind hierbei als Gräben ausgebildet und nicht als kreisförmige Löcher, wie in Fig. 3 dargestellt ausgebildet. Bezüglich der Regelung des Unterdrucks gilt das oben beschriebene.

## Patentansprüche

1. Vorrichtung zur Abnahme mindestens eines chipförmigen Halbleiterbauelements (10) von einer adhäsiven Folie (12), wobei das Halbleiterbauelement (10) auf einer ersten Hauptfläche (120) der Folie (12) angeordnet ist, mit einer Abnahmeeinrichtung (20) für das Halbleiterbauelement (10) und mit einer an einer zweiten Hauptfläche (122) der Folie anordenbaren Anhebeeinrichtung (22), wobei diese Anhebeeinrichtung (22) einen Kontaktbereich (30) zur Anordnung zur Folie (12) aufweist, der seinerseits eine Mehrzahl von Ansaugausnehmungen (50, 52) und Ausnehmungen (42) für stiftförmige Anhebemittel (40) aufweist, wobei alle Ansaugausnehmungen (50, 52) gemeinsam an eine Unterdruckregeleinrichtung (60, 62), oder mindestens zwei Ansaugausnehmungen (50, 52) oder Gruppen von Ansaugausnehmungen (50, 52) an getrennten Unterdruckregeleinrichtungen (60, 62) angeschlossen sind, **dadurch gekennzeichnet, dass** die Unterdruckregeleinrichtung (60, 62) oder die getrennten Unterdruckregeleinrichtungen (60, 62) so konzipiert ist, dass ein definierter Unterdruck an die Folie (12) angelegt wird und zeitlich konstant gehalten oder angepasst wird.

2. Vorrichtung nach Anspruch 1, wobei
die stiftförmigen Anhebemittel (40) ein spitzes oder balliges Ende aufweisen und diese durch den Kontaktbereich (30) der Anhebeeinrichtung (22) hindurchtreten können.

3. Vorrichtung nach Anspruch 1, wobei
die Ansaugausnehmungen (50, 52) als konzentrisch angeordnete Gräben und alternativ oder zusätzlich als auf der Kontaktbereich (30) partiell gleichmäßig oder unregelmäßig verteilte Löcher ausgebildet sind.

4. Vorrichtung nach Anspruch 1, wobei
die Anhebeeinrichtung (22) eine Thermoeinrichtung (70) zur Änderung der Temperatur der adhäsiven Folie (12) aufweist, wobei die Temperatur der Folie (12) mittels dieser Thermoeinrichtung (70) erniedrigt und/oder erhöht werden kann.

5. Vorrichtung nach Anspruch 4, wobei
die Temperatur um mindestens 20°C verändert werden kann.

6. Vorrichtung nach Anspruch 4, wobei
die Thermoeinrichtung (70) ein Peltierelement ist.

7. Verfahren zum Betrieb einer Vorrichtung zur Abnahme mindestens eines chipförmigen Halbleiterbauelements (10) von einer adhäsiven Folie (12), mit folgenden Schritten:
• Anordnen der Anhebeeinrichtung (22) zur Folie (12), wobei ein Kontaktbereich 30 der Anhebeeinrichtung (22) an einer zweiten Hauptfläche (122) der Folie (12), einem abzuhebenden auf einer ersten Hauptfläche (120) angeordneten chipförmigen Halbleiterbauelement (10) gegenüber, anliegt;
• Beaufschlagung von Ansaugausnehmungen (50, 52) der Anhebeeinrichtung (22) mittels zugeordneter Unterdruckregeleinrichtung (60, 62) mit einem konstanten Wert eines Unterdrucks für alle Ansaugausnehmungen (50, 52) oder mit unterschiedlichen Werten des Unterdrucks für unterschiedliche Ansaugausnehmungen (50, 52) oder Gruppen von Ansaugausnehmungen (50, 52);
• Partielles Verformen der Folie (12) im Kontaktbereich (30) durch Anheben der Folie (12) mittels Anhebemittein (40), angeordnet in zugeordneten Ausnehmungen (42) der Anhebeeinrichtung (22), wobei der Unterdruck während der partiellen Verformung der Folie (12) konstant gehalten wird, oder angepasst wird;
• Abnehmen des mindestens einen Halbleiterbauelements (10) mittels einer Abnahmeeinrichtung (20) von der Folie.

8. Verfahren zum Betrieb einer Vorrichtung nach Anspruch 7 wobei
der Unterdruck während der partiellen Verformung um nicht mehr als 10% verändert wird.

9. Verfahren zum Betrieb einer Vorrichtung nach Anspruch 7 wobei
der Unterdruck von mittig angeordneten Ansaugausnehmungen (52) geringer gewählt wird als derjenige von äußeren Ansaugausnehmungen (50).

10. Verfahren zum Betrieb einer Vorrichtung nach Anspruch 7 wobei
über den Kontaktbereich (30) mittels einer Thermoeinrichtung (70) die Temperatur der Folie partiell verändert wird.

11. Verfahren zum Betrieb einer Vorrichtung nach Anspruch 10 wobei
die Thermoeinrichtung (70) dauerhaft oder gepulst betrieben wird.

12. Verfahren zum Betrieb einer Vorrichtung nach Anspruch 11 wobei
bei einem Pulsbetrieb der Thermoeinrichtung (70) diese erst nach dem Anordnen der Anhebeeinrichtung (22) zur Folie (12) aktiviert wird.

## Claims

1. A device for removing at least one chip-shaped semiconductor component (10) from an adhesive film (12), wherein the semiconductor component (10) is arranged on a first main surface (120) of the film (12), having a removal apparatus (20) for the semiconductor component (10) and having a lifting apparatus (22) that can be arranged on a second main surface (122) of the film, wherein the said lifting apparatus (22) has a contact region (30) for arrangement on the film (12), which for its part has a plurality of suction cut-outs (50, 52) and cut-outs (42) for pin-shaped lifting means (40), wherein all the suction cut-outs (50, 52) are connected in common to one vacuum regulation apparatus (60, 62), or at least two suction cut-outs (50, 52) or groups of suction cut-outs (50, 52) are connected to separate vacuum regulation apparatuses (60, 62), **characterised in that** the vacuum regulation apparatus (60, 62) or the separate vacuum regulation apparatuses (60, 62) are designed in such a manner that a defined vacuum is applied to the film (12) and is kept constant or adjusted over time.

2. The device according to Claim 1, wherein
the pin-shaped lifting means (40) have a pointed or crowned end and can pass through the contact region (30) of the lifting apparatus (22).

3. The device according to Claim 1, wherein
the suction cut-outs (50, 52) are configured as concentrically arranged trenches and alternatively or additionally as holes that are distributed partially uniformly or irregularly on the contact region (30).

4. The device according to Claim 1, wherein
the lifting apparatus (22) has a thermal apparatus (70) for changing the temperature of the adhesive film (12), wherein the temperature of the film (12) can be decreased and/or increased by means of the said thermal apparatus (70).

5. The device according to Claim 4, wherein
the temperature can be changed by at least 20°C.

6. The device according to Claim 4, wherein
the thermal apparatus (70) is a Peltier element.

7. A method for operating a device for removing at least one chip-shaped semiconductor component (10) from an adhesive film (12), having the following steps:
• Arrangement of the lifting apparatus (22) on the film (12), wherein a contact region (30) of the lifting apparatus (22) rests on a second main surface (122) of the film (12), opposite a chip-shaped semiconductor component (10) to be removed, which is arranged on a first main surface (120);
• Application of suction cut-outs (50, 52) of the lifting apparatus (22) by means of associated vacuum regulation apparatus (60, 62) having a constant value of a vacuum for all the suction cut-outs (50, 52) or having different values of the vacuum for different suction cut-outs (50, 52) or groups of suction cut-outs (50, 52);
• Partial deformation of the film (12) in the contact region (30) by lifting the film (12) by means of lifting means (40), arranged in associated cut-outs (42) in the lifting apparatus (22), wherein the vacuum is kept constant or is adjusted during the partial deformation of the film (12);
• Removal of the at least one semiconductor component (10) from the film by means of a removal apparatus (20).

8. The method for operating a device according to Claim 7, wherein
the vacuum is changed by no more than 10% during the partial deformation.

9. The method for operating a device according to Claim 7, wherein
the vacuum of centrally arranged suction cut-outs (52) is selected to be lower than that of outer suction cut-outs (50).

10. The method for operating a device according to Claim 7, wherein
the temperature of the film is partially changed over the contact region (30) by means of a thermal apparatus (70).

11. The method for operating a device according to Claim 10, wherein
the thermal apparatus (70) is operated continuously or in a pulsed manner.

12. The method for operating a device according to Claim 11, wherein
in the case of pulsed operation of the thermal apparatus (70), it is only activated once the lifting apparatus (22) is arranged on the film (12).

## Revendications

1. Appareil pour le retrait d'au moins un composant semi-conducteur (10) en forme de puce d'une feuille adhésive (12), le composant semi-conducteur (10) étant disposé sur une première surface principale (120) de la feuille (12), avec un dispositif de prélèvement (20) pour le composant semi-conducteur (10) et avec un dispositif de soulèvement (22) pouvant être disposé contre une deuxième surface principale (122) de la feuille, ledit dispositif de soulèvement (22) présentant une zone de contact (30) pour la disposition sur la feuille (12), ladite zone présentant quant à elle une pluralité d'ouvertures d'aspiration (50, 52) et de cavités (42) pour des moyens de soulèvement (40) en forme de goupilles, toutes les ouvertures d'aspiration (50, 52) étant raccordées ensemble à un dispositif de régulation de dépression (60, 62), ou au moins deux ouvertures d'aspiration (50, 52) ou groupes d'ouvertures d'aspiration (50, 52) étant reliés à des dispositifs de régulation de dépression séparés (60, 62),
**caractérisé en ce que** :
le dispositif de régulation de dépression (60, 62) ou les dispositifs de régulation de dépression séparés (60, 62) sont conçus de telle manière qu'une dépression définie est appliquée sur la feuille (12) et est maintenue constante ou ajustée dans le temps.

2. Appareil selon la revendication 1, dans lequel les moyens de soulèvement (40) en forme de goupilles présentent une extrémité pointue ou arrondie et peuvent traverser la zone de contact (30) du dispositif de soulèvement (22).

3. Appareil selon la revendication 1, dans lequel les ouvertures d'aspiration (50, 52) sont réalisées comme entailles concentriques et, de manière alternative ou complémentaire, comme trous en partie régulièrement ou irrégulièrement répartis sur la zone de contact (30).

4. Appareil selon la revendication 1, dans lequel le dispositif de soulèvement (22) comporte un dispositif thermique (70) pour modifier la température de la feuille adhésive (12), la température de la feuille (12) pouvant être abaissée et/ou élevée au moyen dudit dispositif thermique (70).

5. Appareil selon la revendication 4, dans lequel la température peut être modifiée d'au moins 20 °C.

6. Appareil selon la revendication 4, dans lequel le dispositif thermique (70) est un élément à effet Peltier.

7. Procédé de fonctionnement d'un appareil pour le retrait d'au moins un composant semi-conducteur (10) en forme de puce d'une feuille adhésive (12), comprenant les étapes suivantes :
• disposition du dispositif de soulèvement (22) par rapport à la feuille (12), une zone de contact (30) du dispositif de soulèvement (22) étant appliquée contre une deuxième surface principale (122) de la feuille (12), opposée à un composant semi-conducteur (10) en forme de puce à soulever sur une première surface principale (120) ;
• soumission d'ouvertures d'aspiration (50, 52) du dispositif de soulèvement (22) à une dépression de valeur constante pour toutes les ouvertures d'aspiration (50, 52) par un dispositif de régulation de dépression (60, 62) correspondant, ou à une dépression de valeur différenciée pour différentes ouvertures d'aspiration (50, 52) ou groupes d'ouvertures d'aspiration (50, 52) ;
• déformation partielle de la feuille (12) dans la zone de contact (30) par soulèvement de la feuille (12) par les moyens de soulèvement (40) disposés dans des cavités (42) correspondantes du dispositif de soulèvement (22) ; la dépression étant maintenue constante ou ajustée pendant la déformation partielle de la feuille (12) ;
• retrait de la feuille de l'au moins un composant semi-conducteur (10) au moyen d'un dispositif de prélèvement (20).

8. Procédé de fonctionnement d'un appareil selon la revendication 7, dans lequel la dépression n'est pas modifiée de plus de 10 % pendant la déformation partielle.

9. Procédé de fonctionnement d'un appareil selon la revendication 7, dans lequel la dépression des ouvertures d'aspiration (52) à disposition centrale est sélectionnée inférieure à celle des ouvertures d'aspiration (50) extérieures.

10. Procédé de fonctionnement d'un appareil selon la revendication 7, dans lequel la température de la feuille est partiellement modifiée au moyen d'un dispositif thermique (70) au-dessus de la zone de contact (30).

11. Procédé de fonctionnement d'un appareil selon la revendication 10, dans lequel le dispositif thermique (70) est mis en service de manière continue ou par impulsions.

12. Procédé de fonctionnement d'un appareil selon la revendication 11, dans lequel, en cas de fonctionnement par impulsions du dispositif thermique (70), celui-ci n'est activé qu'après disposition du dispositif de soulèvement (22) sur la feuille (12).
